# FASCICULE DE BREVET EUROPEEN

(11) **EP 1 618 611 B1**
(45) Date de publication et mention de la délivrance du brevet: **23.07.2008**
(21) Numéro de dépôt: 04742859.4
(22) Date de dépôt: 27.04.2004
(51) Int. Cl.: H01L 31/0224, H01L 31/18

(54) **PROCEDE DE REALISATION D UN DISPOSITIF SEMI-CONDUCTEUR A MET ALLISATIONS AUTO-ALIGNEES.**
VERFAHREN ZUM HERSTELLEN EINER HALBLEITER-VORRICHTUNG MIT SELBSTAUSRICHTENDEN METALLISCHEN KONTAKTEN
METHOD FOR PRODUCTION OF A SEMICONDUCTOR DEVICE WITH AUTO-ALIGNED METALLISATIONS

(30) Priorité: 29.04.2003 FR 0350136
(43) Date de publication de la demande: 25.01.2006
(73) Titulaire: COMMISSARIAT A L'ENERGIE ATOMIQUE, 75015 Paris (FR)
(72) Inventeur: RIBEYRON, Pierre-Jean, F-38330 SAINT ISMIER (FR)
(74) Mandataire: Poulin, Gérard
(86) Numéro de dépôt international: PCT/FR2004/050173
(87) Numéro de publication internationale: WO 2004/097945

(56) Documents cités:
- US-A- 4 927 770
- US-B1- 6 396 046
- SWANSON R M ET AL: "POINT CONTACT SILICON SOLAR CELLS" IEEE TRANSACTIONS ON ELECTRON DEVICES, IEEE INC. NEW YORK, US, vol. 31, no. 5, mai 1984 (1984-05), pages 661-664, XP001080038 ISSN: 0018-9383
- TILFORD C L ET AL: "Development of a 10 kW reflective dish PV system" PROCEEDINGS OF THE PHOTOVOLTAIC SPECIALISTS CONFERENCE. LOUISVILLE, MAY 10 - 14, 1993, NEW YORK, IEEE, US, vol. CONF. 23, 10 mai 1993 (1993-05-10), pages 1222-1227, XP010113231 ISBN: 0-7803-1220-1
- VERLINDEN P ET AL: "MULTILEVEL METALLIZATION FOR LARGE AREA POINT-CONTACT SOLAR CELLS" PROCEEDINGS OF THE INTERNATIONAL PHOTOVOLTAIC ENERGY CONFERENCE. FLORENCE, MAY 9 - 13, 1988, DORDRECHT, KLUWER, NL, vol. 2 CONF. 8, 9 mai 1988 (1988-05-09), pages 1466-1471, XP000044541

## Description

### DOMAINE TECHNIQUE

La présente invention est relative à un procédé de réalisation d'un dispositif semi-conducteur à métallisations auto-alignées placées sur une même face d'un substrat semi-conducteur. Un tel dispositif peut être, par exemple, une cellule solaire possédant des jeux de métallisations en peigne imbriqués, et le procédé convient particulièrement à la réalisation de cellules solaires sur silicium monocristallin en couche mince. Le procédé peut s'appliquer bien entendu à d'autres dispositifs semi-conducteurs possédant des métallisations imbriquées notamment en peigne.

### ÉTAT DE LA TECHNIQUE ANTÉRIEURE

Une description d'un procédé de réalisation de cellules solaires est donnée par exemple dans le brevet US-A-6 426 235. Dans ce document les cellules solaires ont deux jeux de métallisations en peigne inter-digités en face arrière et c'est la face avant qui est éclairée. On peut se référer à la figure 1A qui montre un exemple de cellule solaire conforme à celle décrite dans ce document. Sur cette figure la référence 1 représente un substrat en matériau semi-conducteur d'un premier type de conductivité, par exemple de type p, comportant en surface une couche 3 dopée d'un second type de conductivité (de type n⁺). Le substrat 1, par exemple en silicium, va servir d'anode tandis que la couche 3 va servir de cathode. La couche 3 est partiellement ôtée à certains endroits pour mettre à nu le substrat 1. Au moins une couche 4 d'oxyde est ensuite déposée sur la couche 3 et le substrat 1 mis à nu et des ouvertures sont pratiquées dans cette couche d'oxyde 4 pour atteindre, d'une part le substrat 1 et d'autre part la couche 3, afin de pouvoir délimiter des régions semi-conductrices ayant des types de conductivités opposés, correspondant à l'anode et à la cathode, devant être connectées respectivement à un premier jeu de métallisations 5 en peigne et à un second jeu de métallisations 6 en peigne. Ces deux jeux de métallisations en peigne 5, 6 sont inter-digités. Dans l'exemple, le premier jeu de métallisations 5 en peigne correspond à l'anode de la cellule et le second jeu de métallisations en peigne 6 correspond à la cathode de la cellule.

Les deux jeux de métallisations 5, 6 en peigne s'étendent au-dessus de la couche diélectrique 4 mais bien sûr ne doivent pas venir en contact l'un avec l'autre ce qui créerait un court-circuit. Or, il est très difficile de bien positionner entre eux les jeux de métallisations 5, 6 en peigne. La réalisation de ces métallisations en peigne se fait généralement par sérigraphie. Il est nécessaire de limiter au minimum la distance séparant deux métallisations successives appartenant à des jeux différents pour que la plus grande surface possible soit pourvue de métallisations, en effet ces métallisations ont également un rôle de réflecteur de lumière puisqu'elles sont placées sur la face arrière de la cellule. Cette distance est typiquement comprise entre environ une dizaine voire une centaine de micromètres pour obtenir des cellules solaires performantes. Avec de telles distances, le risque de court-circuit entre les deux jeux de métallisations en peigne est grand.

Une étape finale consiste à fixer un support isolant électrique au-dessus des jeux de métallisations en peigne de manière à pouvoir séparer un film mince du substrat, si on a prévu au préalable dans le substrat une couche fragilisée. La fixation par collage n'est pas aisée puisque la surface devant recevoir le support comporte un certain nombre de reliefs dus aux jeux de métallisations et l'épaisseur de colle n'est pas uniforme.

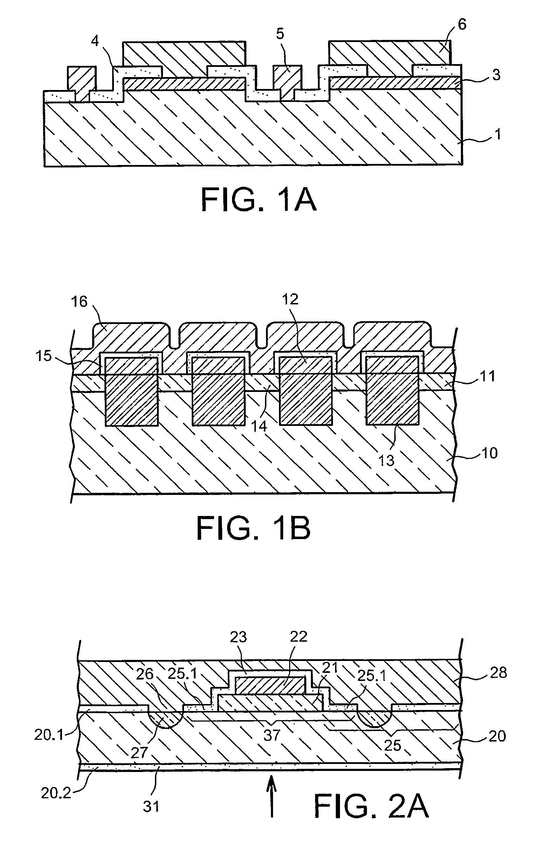

Dans la demande de brevet EP-A-0 776 051, il est décrit également une cellule solaire ayant deux jeux de métallisations en peigne inter-digités placés sur la face arrière de la cellule. La figure 1B montre de manière schématique une telle cellule solaire. Dans un substrat semi-conducteur 10 recouvert d'une couche superficielle 11 d'un premier type de conductivité (de type n⁺), on dépose un premier jeu de métallisations 12 en peigne par exemple en aluminium. Sur la coupe de la figure 1B, on ne voit qu'une succession de dents du peigne. Ce jeu de métallisations 12 en peigne est soumis à un traitement thermique approprié de manière à ce qu'il diffuse dans le substrat à travers la couche du premier type de conductivité pour former un motif 13 correspondant d'un second type de conductivité (de type p+), le motif 13 comporte des dents espacées les unes des autres par des régions 14 de la couche 11 du premier type de conductivité. Une couche d'oxyde 15 est déposée en surface, elle recouvre le premier de jeu de métallisations 12 en peigne et les régions 14 de la couche 11 du premier type de conductivité. La couche d'oxyde 15 est ôtée localement pour mettre à nu les régions 14. Une couche conductrice 16 est déposée en surface. Cette couche 16 surmonte la couche d'oxyde 15 sur les bandes conductrices 12 et les régions 14 de la couche 11 du premier type de conductivité. Cette couche conductrice 16 contribue à former un second jeu de métallisations qui coopère avec les zones 14 du premier type de conductivité. Par rapport à la structure de la figure 1A, les deux jeux de métallisations 12, 16 en peigne sont isolés électriquement l'un de l'autre par la couche diélectrique 15. L'inconvénient de ce type de cellule solaire est que des risques de court-circuit existent entre les régions 14 du premier type de conductivité et le motif 13 du second type de conductivité car ils sont accolés.

Le document US-A-4 927 770 décrit un procédé de realisation d'un dispositif semi-conducteur.

### EXPOSÉ DE L'INVENTION

La présente invention a justement comme but de proposer un procédé de réalisation d'un dispositif semi-conducteur qui ne présente pas les inconvénients mentionnés ci-dessus, à savoir ces risques de court-circuit entre les deux jeux de métallisations et entre les régions de conductivité de types opposés et qui de plus est bon marché.
un procédé de réalisation d'un dispositif semi-conducteur comportant les étapes suivantes :
- réalisation sur une première face principale d'un substrat semi-conducteur d'une région dopée d'un premier type de conductivité et d'au moins une fenêtre délimitant la dite région,
- dépôt d'une première zone de métallisation sur la région dopée du premier type de conductivité,
- dépôt d'une couche diélectrique sur au moins la fenêtre et la première zone de métallisation,
- gravure d'au moins une première ouverture dans la couche diélectrique au niveau de la fenêtre mettant à nu le substrat, destinée à accueillir une région dopée d'un second type de conductivité tout en aménageant latéralement une portion non dopée de substrat entre la région dopée du second type de conductivité et la région dopée du premier type de conductivité,
- dopage du substrat conduisant à la région dopée du second type de conductivité,
- dépôt d'une seconde zone de métallisation recouvrant la couche diélectrique et venant en contact avec la région dopée du second type de conductivité.

Ainsi, le dispositif semi-conducteur obtenu est bon marché car aucune étape de lithographie n'est utilisée lors de sa réalisation, contrairement à l'art antérieur, ces étapes de lithographie étant coûteuses et incompatibles industriellement avec une application préférentielle de cellules solaires.

La région dopée du premier type de conductivité peut être réalisée par dépôt d'une couche dopée du premier type de conductivité sur la face principale du substrat et gravure dans la couche dopée du premier type de conductivité de la fenêtre mettant à nu le substrat.

En variante, la région dopée du premier type de conductivité peut être réalisée par formation d'une couche diélectrique sur la face principale du substrat, par décapage d'une partie du diélectrique à l'aide d'une pâte décapante par sérigraphie formant une zone décapée au contour de la future région dopée du premier type de conductivité, par dopage de la zone décapée, par retrait du diélectrique restant pour former la fenêtre.

Dans une autre variante, la région dopée du premier type de conductivité peut être réalisée par formation d'une couche diélectrique sur la face principale du substrat, par décapage d'une partie du diélectrique à l'aide d'une pâte décapante par sérigraphie formant une zone décapée au contour de la future région dopée du premier type de conductivité, par dopage de la zone décapée, le diélectrique restant formant la fenêtre.

Au moins une gravure peut être une gravure laser, ce qui permet d'obtenir une gravure fine.

En variante la gravure peut être une gravure par sérigraphie à l'aide d'une pâte apte à décaper du matériau diélectrique.

Le dépôt d'au moins une zone de métallisation se fait par sérigraphie.

La région dopée du premier type de conductivité et la région dopée du second type de conductivité peuvent être imbriquées l'une dans l'autre.

La première ouverture est plus petite en superficie que la fenêtre, ce qui permet d'aménager la portion non dopée du substrat.

Le dépôt de la première zone de métallisation sur la région dopée du premier type de conductivité peut se faire avant ou après l'étape de gravure de la fenêtre.

Il est préférable que la gravure de la couche dopée du premier type de conductivité attaque le substrat semi-conducteur pour éviter tout court circuit entre les régions dopées. L'étape de dépôt d'une seconde zone de métallisation peut précéder celle de dopage du substrat conduisant à la région dopée du second type de conductivité, le matériau de la seconde zone de métallisation étant recuit de manière à diffuser dans le substrat au niveau de la première ouverture.

Le substrat peut être formé d'un empilement avec une couche fragilisée et une couche mince, la couche fragilisée étant en profondeur, la face principale du substrat sur laquelle la couche dopée du premier type de conductivité est déposée, étant une face de la couche mince.

Le procédé peut comporter une étape de fixation de la seconde zone de métallisation sur un support isolant électrique.

Cette étape peut être suivie d'une étape de dissociation de la couche mince du substrat au niveau de la couche fragilisée.

Le procédé peut comporter une étape de protection de la couche mince du côté où elle a été dissociée.

L'étape de gravure de la première ouverture peut inclure la gravure d'une seconde ouverture au niveau de la première zone de métallisation mettant à nu une plage de métallisation dont est dotée la première zone de métallisation.

L'étape de dépôt de la seconde zone de métallisation épargne la seconde ouverture.

Le dispositif peut être formé d'une ou plusieurs cellules solaires. Les cellules solaires peuvent être connectées en série et/ou en parallèle.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
Les figures 1A, 1B (déjà décrites) montrent en coupe des cellules solaires de l'art antérieur ;
La figure 2A montre en coupe un dispositif obtenu par le procédé de l'invention et la figure 2B un module de cellules solaires obtenu par le procédé de l'invention ;
Les figures 3, 4A, 4B, 4C, 4D, 4E, 5A, 5B, 6A, 6B, 7A1, 7A2, 7B, 8A, 8B, 9A, 9B, 10 illustrent différentes étapes de procédés s selon l'invention pour la réalisation d'un dispositif semi-conducteur selon l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

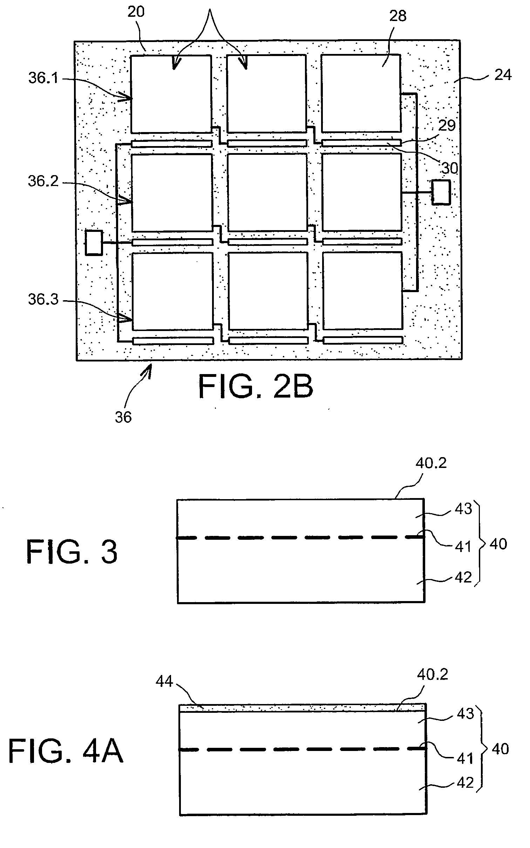

On va maintenant se référer à la figure 2A qui montre en coupe un dispositif semi-conducteur obtenu par un procédé selon l'invention. Dans cet exemple il s'agit d'une cellule solaire, mais il pourrait s'agir d'un autre dispositif semi-conducteur. Cette cellule solaire comporte un substrat semi-conducteur 20 que l'on suppose dans cet exemple épais. Ce substrat semi-conducteur 20 peut être par exemple en silicium. Dans une variante que l'on décrira par la suite aux figures 3 à 10, le substrat semi-conducteur est mince.

Le substrat semi-conducteur 20 comporte, au niveau d'une première face principale 20.1 qui dans cet exemple est du côté de la face arrière de la cellule solaire, une région dopée 21 d'un premier type de conductivité. On suppose que cette région dopée 21 est de type n+.

Cette région dopée 21 du premier type de conductivité est connectée à une première zone 22 de métallisation, cette première zone 22 de métallisation est la plus proche du substrat semi-conducteur. Dans l'exemple, la première zone 22 de métallisation est digitiforme avec un seul doigt se terminant par une plage de métallisation 29. La plage de métallisation 29 n'est visible que sur la figure 2B, à laquelle on se réfère également, et qui représente un module de cellules solaires conformes à celle de la figure 2A.

La première zone 22 de métallisation pourrait être dotée de plusieurs doigts reliés ensemble par une plage de métallisation et ainsi prendre la forme d'un peigne comme on le verra par la suite.

La première zone 22 de métallisation ne recouvre que partiellement la région dopée 21 du premier type de conductivité, une partie 24 est épargnée. Une couche diélectrique 23 recouvre à la fois la première zone 22 de métallisation, la partie 24 ainsi que la région 25 du substrat 20 se trouvant de part et d'autre de la région dopée 21 du premier type de conductivité. La couche diélectrique 23 possède des premières ouvertures 26 fines de part et d'autre de la région dopée 21 du premier type de conductivité. Ces ouvertures 26 délimitent sensiblement une région dopée 27 ayant un second type de conductivité opposé au premier type (dans l'exemple de type p+). Cette région dopée 27 du second type de conductivité est disjointe de la région dopée 21 du premier type de conductivité. Cela signifie qu'entre les deux régions dopées ayant des types de conductivité opposés, il subsiste latéralement une portion 25.1 non dopée du substrat 20 recouverte de la couche diélectrique 23. Cette portion 25.1 non dopée a un rôle de barrière entre les deux régions dopées 21, 27 ayant des types de conductivités opposés.

Cela n'était pas le cas dans la demande de brevet européen citée plus haut dans laquelle une région dopée du premier type de conductivité et une région dopée du second type de conductivité étaient toujours jointives latéralement, c'est à dire accolées.

La couche diélectrique 23 comporte également une seconde ouverture 30 qui laisse apparaître totalement ou partiellement la plage de métallisation 29 de la première zone 22 de métallisation comme le montre la figure 2B.

La couche diélectrique 23 ainsi que les premières ouvertures 26 à l'exception de la seconde ouverture 30 sont recouvertes d'une couche 28 électriquement conductrice qui forme une seconde zone 28 de métallisation connectée à la région dopée 27 du second type de conductivité, au niveau des premières ouvertures 26. Cette seconde zone 28 de métallisation présente des métallisations espacées les unes des autres et forme un contact ohmique avec la région dopée 27. La seconde zone 28 de métallisation est la plus éloignée du substrat semi-conducteur 20. Ainsi dans le dispositif semi-conducteur selon l'invention, le risque de court-circuit entre une région dopée 21 du premier type de conductivité et une région dopée 27 du second type de conductivité est éliminé même si les lieux de connexion d'une région dopée d'un type de conductivité avec sa zone de métallisation et ceux de l'autre région dopée avec sa zone de métallisation sont très proches les uns des autres.

La première zone 22 de métallisation et la seconde zone 28 de métallisation sont empilées et séparées par du diélectrique 23, ainsi elles sont facilement auto-alignées. Il n'y a ainsi pas de risque de court-circuit entre la première et la seconde zone de métallisation.

Dans l'empilement, le diélectrique 23 et la zone de métallisation 22 la plus éloignée du substrat 20 laissent apparaître une partie de la zone de métallisation 27 la moins éloignée du substrat.

La couche électriquement conductrice 28 aura avantageusement une face libre sensiblement plane, elle comble ainsi les différences de reliefs dues notamment à l'empilement de la région dopée 21 du premier type de conductivité, de la première zone 22 de métallisation et de la couche diélectrique 23 sur le substrat 20. Cette planéité est intéressante également pour l'encapsulation en module des substrats massifs. Dans le cas d'une cellule solaire, la seconde face principale 20.2 du substrat semi-conducteur 20 peut être recouverte d'une couche 31 d'isolant électrique de protection, par exemple en nitrure de silicium, cette couche 31 étant transparente pour l'éclairement reçu puisqu'elle se trouve sur la face avant de la cellule solaire. La flèche matérialise l'éclairement que reçoit la cellule solaire. Cette couche 31 a également un rôle de passivation de surface du substrat 20 et de couche antiréflective pour permettre à une quantité maximale de lumière de pénétrer dans le substrat.

Sur la figure 2B, on voit que la seconde zone 28 de métallisation laisse apparaître la plage de métallisation 29 mise à nu par la seconde ouverture 30.

On peut ainsi regrouper, par une fabrication par lots, sur un même substrat 20, en un module 36, plusieurs de ces cellules solaires 35 dans un montage série et/ou parallèle. Ce module 36 comporte neuf cellules 35 montées en trois groupes 36.1, 36.2, 36.3 de trois cellules en série disposées selon des lignes, les trois groupes série 36.1, 36.2, 36.3 étant montés en parallèle.

On vient de décrire une configuration dans laquelle la région dopée 27 du second type de conductivité s'étendait de part et d'autre de la région dopée 21 du premier type de conductivité. On peut envisager que l'inverse soit possible comme on va le montrer par la suite. De manière plus générale, la région dopée du premier type de conductivité et la région dopée du second type de conductivité sont imbriquées l'une dans l'autre, tout en restant séparées latéralement l'une de l'autre par la portion non dopée 25.1 du substrat. Les métallisations de la seconde zone 28 de métallisation définissent au moins un espace 37 (dans lequel s'étend la région dopée 21 du premier type de conductivité) et la connexion de la première zone 22 de métallisation avec la région dopée 21 avec laquelle elle coopère se fait dans l'espace 37.

On va maintenant s'intéresser au procédé de réalisation d'un dispositif semi-conducteur conforme à l'invention. On suppose que le dispositif semi-conducteur ainsi réalisé est une cellule solaire en silicium monocristallin en couche mince. On se réfère aux figures 3 à 10.

On part d'un substrat 40 semi-conducteur par exemple à base silicium monocristallin présentant à une profondeur donnée une couche fragilisée 41 de manière à permettre ultérieurement le détachement d'une couche mince 43, se trouvant d'un côté de la couche fragilisée 41, du reste du substrat 40. Cette couche fragilisée 41 peut par exemple être formée à la surface d'un substrat de base 42 de silicium monocristallin massif par un traitement d'anodisation, ou par implantation ionique d'espèces gazeuses par exemple d'hydrogène dans le substrat de base 42 ou par tout autre procédé de fragilisation.

La couche mince 43 qui se trouve au-dessus de la couche fragilisée 41 peut être formée en totalité ou en partie par épitaxie. On effectue en surface une croissance épitaxiale de silicium pour obtenir une épaisseur de quelques dizaines de micromètres au-dessus de la couche fragilisée 41 (figure 3). L'épitaxie peut être une épitaxie en phase gazeuse ou en phase liquide par exemple.

On aurait toutefois pu se passer d'épitaxie pour réaliser la couche mince 43 si l'implantation ionique est suffisamment profonde.

On va ensuite réaliser une région dopée 44.1 d'un premier type de conductivité par exemple n+. On déposera ensuite une première zone de métallisation 46 sur la région dopée 44.1 du premier type de conductivité.

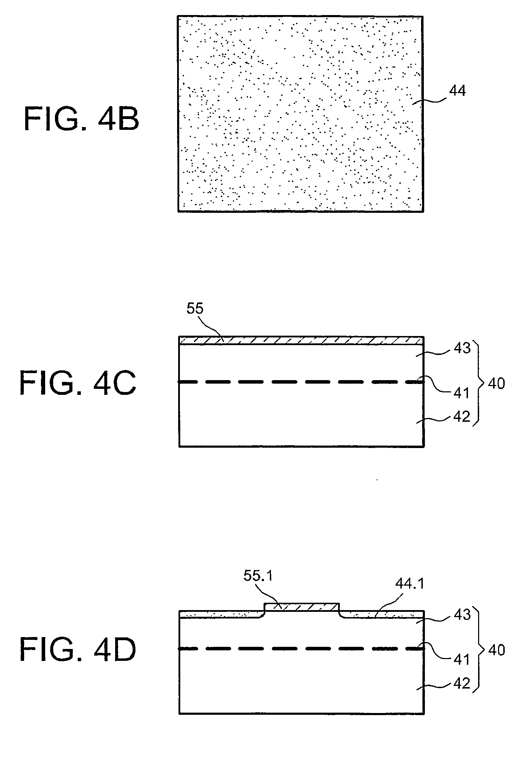

Dans un premier mode de réalisation, on réalise une couche dopée 44 sur toute la surface 40.2 du substrat 40. Cette couche dopée 44 peut être réalisée par diffusion d'atomes de phosphore ou implantation d'ions phosphore dans le substrat 40 (en fait dans la couche mince 43 du substrat 40) ou par ajout d'un dopant approprié (par exemple de la phosphine PH₃) en fin de croissance épitaxiale de la couche épitaxiée formant la couche mince. Cette couche dopée 44 est représentée sur les figures 4A, 4B.

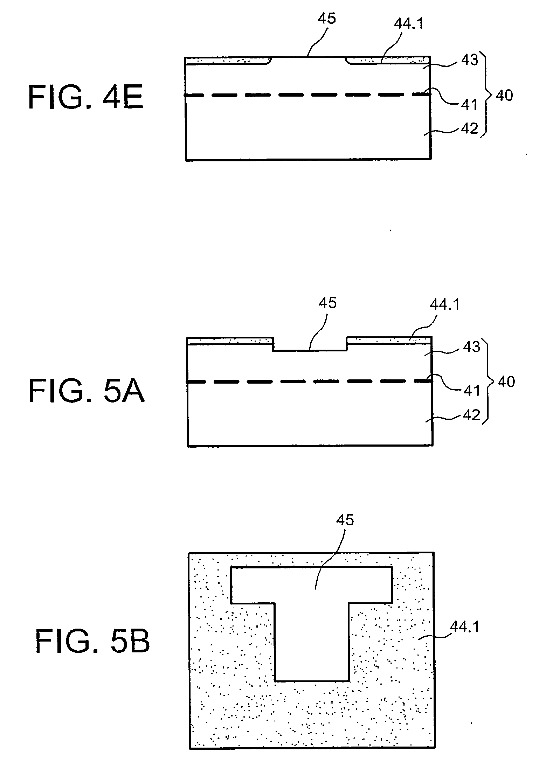

On va ensuite délimiter la couche dopée 44 pour obtenir la région dopée 44.1 du premier type de conductivité. Pour cela, on réalise au moins une fenêtre 45 dans la couche dopée 44 afin de mettre à nu le substrat 40 qui se trouve dessous. Par la suite, on a employé le terme substrat mais il s'agit de la couche mince du substrat s'il y a une couche mince. La fenêtre 45 est visible sur les figures 5A, 5B.

Cette étape peut être réalisée par gravure laser. La gravure laser est une méthode précise et rapide, ce qui est avantageux. Cela fait baisser le coût de fabrication du dispositif selon l'invention. Le motif de la fenêtre 45 est tel qu'il va contribuer à délimiter la région dopée 44.1 du premier type de conductivité et à loger la future région dopée du second type de conductivité, en incluant latéralement, la portion 40.1 non dopée de substrat 40 séparant la région dopée 44.1 du premier type de conductivité de la future région dopée du second type de conductivité. Dans l'exemple décrit la fenêtre 45 est en forme de T mais ce n'est qu'un exemple en aucun cas limitatif, la fenêtre 45 pourrait bien sûr comporter plusieurs doigts au lieu d'un seul.

De préférence, l'épaisseur gravée pour faire la fenêtre 45 est supérieure à celle de la couche dopée 44. La gravure attaque le substrat 40. La raison en est qu'ainsi on diminue encore plus le risque court-circuit entre la région dopée 44.1 du premier type de conductivité et la future région dopée du second type de conductivité.

Dans un autre mode de réalisation, la région dopée 44.1 du premier type de conductivité est réalisée par sérigraphie. Sur le substrat 40, on forme une couche diélectrique 55, par exemple en oxyde ou en nitrure de silicium (figure 4C). Une couche en oxyde de silicium peut être réalisée par oxydation thermique. On décape dans ce diélectrique 55 une zone dont le contour correspond à celui de la future région dopée du premier type de conductivité. Ce décapage se fait par sérigraphie à l'aide d'une pâte décapante à travers un écran de sérigraphie (non représenté). Les techniques de sérigraphie sont connues en microélectronique. La pâte décapante est adaptée à la nature du diélectrique 55 à ôter. Le dopage peut se faire comme décrit précédemment par exemple par diffusion d'atomes de phosphore au niveau de la zone décapée ou par implantation d'ions phosphore (figure 4D). Le diélectrique restant 55.1 assure une protection du substrat vis-à-vis du dopage. On peut ensuite ôter par attaque chimique sélective, par exemple, le diélectrique restant de manière à former une fenêtre 45 qui délimite la région dopée 44.1 du premier type de conductivité (figure 4E). Cette fenêtre laisse apparaître le substrat 40 non dopé. La gravure chimique n'attaque pas le substrat.

En variante, on peut conserver le diélectrique qui reste après l'étape de décapage (figure 4D). Ce diélectrique forme la fenêtre référencée 55.1, elle délimite la région dopée 44.1 du premier type de conductivité.

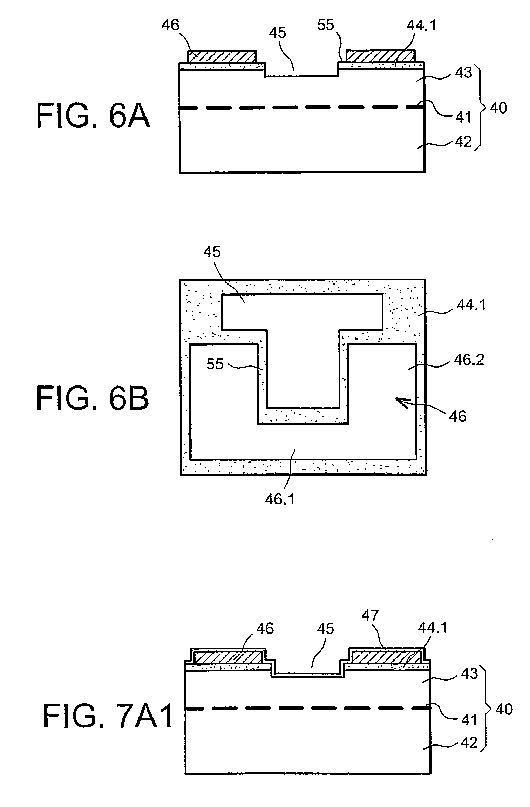

Une première zone de métallisation 46 est connectée à la région dopée 44.1 du premier type de conductivité. La réalisation de cette première zone de métallisation 46 (ou métallisation anodique) est une étape de métallisation par exemple par sérigraphie ou impression par jet métallique. La métallisation peut être à base d'un métal noble tel l'argent ou l'or. La première zone 46 de métallisation comporte des métallisations 46.2 espacées les unes des autres qui peuvent prendre par exemple la forme de doigts 46.2. Ces doigts 46.2 sont reliés à une extrémité à la manière d'un peigne de manière à comporter une plage de métallisation 46.1. Dans l'exemple décrit, cette étape de métallisation a lieu après l'étape de gravure de la fenêtre 45. La première zone 46 de métallisation est visible sur les figures 6A, 6B. Ces figures sont basées sur la configuration obtenue avec le premier mode de réalisation de la région dopée du premier type de conductivité. On comprend bien qu'avec les configurations dans lesquelles la région dopée a été obtenue après une étape de sérigraphie, on procéderait de manière similaire, c'est pourquoi aucune illustration n'a été faite.

Il est bien entendu que cette étape de métallisation pourrait avoir lieu après l'étape d'ouverture de la fenêtre 45. La première zone 46 de métallisation peut ne recouvrir que partiellement la région dopée 44.1 du premier type de conductivité comme sur les figures 6A, 6B ou au contraire la recouvrir entièrement.

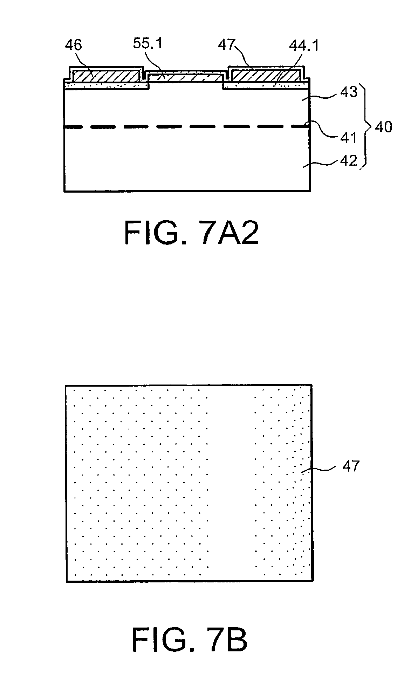

L'étape suivante est une étape de dépôt d'une couche diélectrique 47 sur la structure obtenue, elle recouvre directement la première zone 46 de métallisation, éventuellement la région dopée 44.1 du premier type de conductivité et le substrat 40 mis à nu par la fenêtre 45. La couche diélectrique 47 est visible sur les figures 7A1, 7A2, 7B. La figure 7A1 se base sur la configuration dans laquelle la région dopée du premier type de conductivité a été obtenue par le premier mode de réalisation. La figure 7A2 se base sur la configuration dans laquelle la région dopée du premier type de conductivité a été obtenue par sérigraphie, la fenêtre 55.1 qui contribue à délimiter cette région étant en matériau diélectrique. La figure 7B s'applique aux deux cas.

La couche diélectrique 47 va servir à isoler la première zone 46 de métallisation de la future seconde zone de métallisation réalisée ultérieurement. Le matériau diélectrique peut être par exemple un oxyde de silicium ou un nitrure de silicium. Il peut être déposé par exemple par une technique de dépôt chimique en phase vapeur assisté par plasma (connu sous la dénomination anglo-saxonne PECVD pour Plasma Enhanced Chemical Vapor Déposition) ou tout autre technique appropriée.

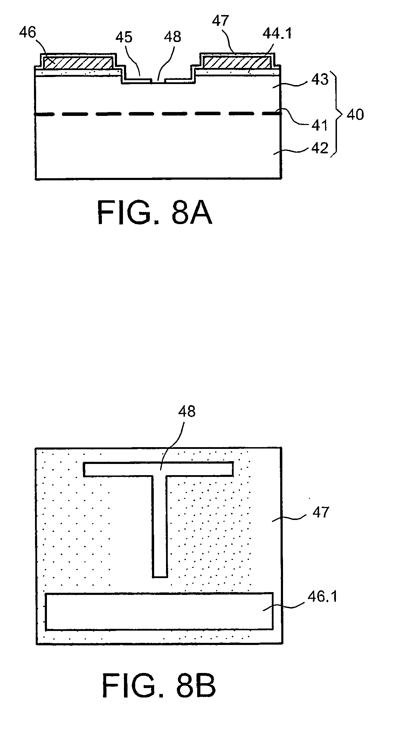

L'étape suivante est une étape de gravure de la couche diélectrique 47 pour mettre à nu le substrat 40 au niveau de la fenêtre 45 (ou 55.1). On réalise par cette étape une première ouverture 48 de superficie plus petite que celle de la fenêtre 45 (figures 8A, 8B). Ces figures concernent le premier mode de réalisation de la région dopée du premier type de conductivité. Le contour de cette première ouverture 48 correspond à celui voulu pour la future région dopée de second type de conductivité qui va être réalisée par la suite. Autour de cette ouverture se trouve la portion 40.1 non dopée de substrat 40 qui sert latéralement de barrière entre la région dopée 44.1 de premier type de conductivité et la future région dopée de second type de conductivité. Cette portion 40.1 non dopée de substrat 40 peut avoir une largeur d'environ 10 micromètres. Cette étape de gravure est avantageusement réalisée par laser lorsque la première ouverture 48 est très fine. On peut facilement atteindre des largeurs d'ouverture de l'ordre de quelques dizaines de micromètres. D'autres méthodes de gravure peuvent être employées, si elles sont compatibles avec la finesse de l'ouverture désirée. On peut en particulier citer la sérigraphie à l'aide d'une pâte décapante appropriée à la nature du diélectrique 47.

L'étape de gravure peut également réaliser une seconde ouverture 49 dans la couche diélectrique 47 au niveau de la première zone 46 de métallisation pour mettre à nu la plage de métallisation 46.1 (figures 8A, 8B). Cette mise à nu peut être partielle ou totale.

Il faut ensuite réaliser la zone dopée 50 du second type de conductivité et la seconde zone 51 de métallisation devant être connectée avec elle. Il est possible de réaliser ces deux éléments en même temps en déposant au-dessus de la couche de diélectrique 47, dans la première ouverture 48, mais pas dans la seconde ouverture 49 (si elle existe), un dépôt métallique 51 par exemple à base d'aluminium ou d'un alliage aluminium argent par sérigraphie ou impression par jet métallique. Ce dépôt est suivi d'un recuit thermique à des températures de l'ordre de 400°C à 800°C. Ce recuit thermique permet aux atomes métalliques de diffuser dans le substrat 40, cette diffusion conduisant au dopage du second type de conductivité de la partie mise à nu par la première l'ouverture 48. On a ainsi formé la zone dopée 50 du second type de conductivité. Il s'agit dans cet exemple d'un dopage de type p⁺. Cette zone dopée 50 est également appelée champ de surface arrière.

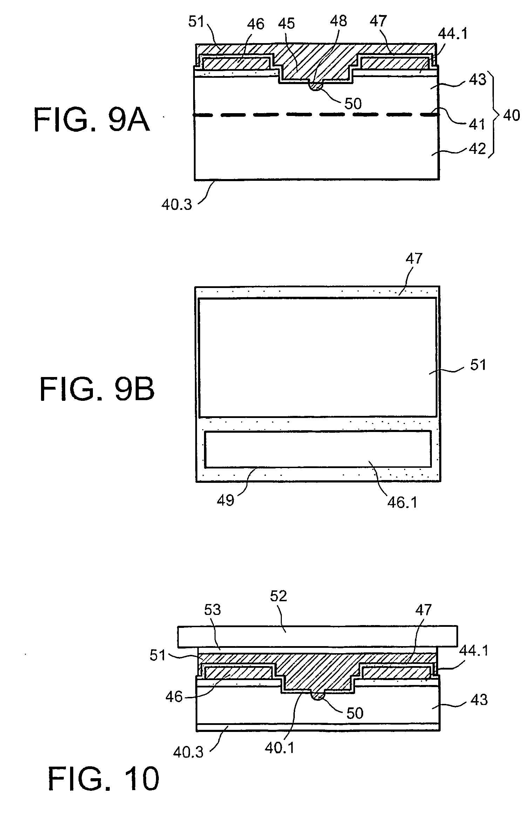

La couche métallique 51 forme la seconde zone 51 de métallisation (ou métallisation cathodique) qui coopère avec la région dopée 50 du second type de conductivité (figures 9A, 9B). Ainsi la seconde zone 51 de métallisation est auto-alignée avec la première zone 46 de métallisation sans pour autant à avoir à utiliser un masque complexe de lithographie. La seconde zone 51 de métallisation est parfaitement isolée électriquement de la première zone 46 de métallisation par la couche diélectrique 47.

Au lieu de réaliser la région dopée 50 ayant le second type de conductivité avec le matériau de la seconde zone de métallisation en tant que dopant, il est possible dans une première étape de réaliser un dopage du substrat 40 au niveau de la première ouverture 48 par diffusion ou implantation ionique avec un matériau approprié. Dans l'exemple ce matériau, qui peut être du bore, conduit à un dopage de type p+. Ultérieurement on réalise la métallisation conduisant à la seconde zone 51 de métallisation.

La zone de métallisation 46 la moins éloignée du substrat peut être configurée en peigne avec des doigts 46.2 et une plage de métallisation 46.1 reliant les doigts, le diélectrique 47 et la zone de métallisation 51 la plus éloignée du substrat laissant apparaître au moins partiellement la plage de métallisation 46.1.

Toutes les étapes qui viennent d'être décrites peuvent être utilisées pour réaliser un dispositif semi-conducteur similaire à celui décrit aux figures 2A, 2B sur substrat épais. Ainsi dans les deux exemples présentés, une des zones de métallisation au moins comporte des contacts séparés par au moins un espace (référencé 55 sur les figures 6A, 6B). Ces contacts se trouvent au niveau de la région dopée avec laquelle la zone de métallisation coopère. La connexion de l'autre zone de métallisation avec la région dopée correspondante se fait dans l'espace 55.

On rapporte ensuite, par exemple par collage, un support 52 isolant électrique et bas coût par exemple en verre, matière plastique supportant les températures relativement élevées (de l'ordre de 350°C par exemple) pour être compatible avec les étapes technologiques ultérieures, céramique ou autre, sur la seconde zone 51 de métallisation la plus éloignée du substrat (figure 10). La colle est référencée 53. La distribution de colle 53 peut se faire par sérigraphie pleine plaque de manière aisée. L'épaisseur de colle 53 est sensiblement constante si la surface libre de la seconde zone 51 de métallisation est sensiblement plane. Le collage est beaucoup plus facile que s'il devait se faire sur une face avec des reliefs comme cela se passe dans le brevet américain US-A-6 426 235 cité au début. Il fallait alors remplir soigneusement de colle les zones entre les métallisations.

On peut alors séparer la couche mince 43 du substrat de base 42 au niveau de la couche fragilisée 41 (figure 10) grâce à un traitement thermique et/ou l'application de forces mécaniques par exemple.

On peut prévoir une couche de protection 54 sur la face de la couche mince 43 au niveau de la séparation (figure 10). On peut par exemple déposer une couche de diélectrique par exemple de l'oxyde de silicium ou du nitrure silicium, déposé par exemple à 350°C. Il faut que cette couche qui joue un rôle de couche antiréflective, de passivation et de protection soit transparente à l'éclairement auquel le dispositif va être exposé si le dispositif décrit est une cellule solaire.

Un intérêt de la métallisation formant la seconde zone 51 de métallisation est d'une part qu'elle recouvre pratiquement toute la face traitée du substrat 40 et d'autre part qu'elle est réfléchissante de la lumière ayant pénétré dans le substrat 40 sans être absorbée. Elle permet un très bon confinement optique et un rendement de conversion amélioré par rapport aux cellules n'ayant pas cet élément réfléchissant. Cet avantage se fait particulièrement sentir dans les cellules ayant un substrat de faible épaisseur, inférieur à environ 50 micromètres, de type cellule en couche mince de silicium monocristallin puisque de la lumière peut traverser toute l'épaisseur sans être absorbée.

Un autre avantage de cette métallisation est qu'elle peut être réalisée sans alignement fin. On peut ainsi s'affranchir des problèmes d'alignement de masques inhérents aux métallisations imbriquées ou inter-digitées. Il suffit d'épargner la plage de métallisation 46.1 de la première zone 46 de métallisation réalisée.

Un tel procédé peut aussi bien être utilisé pour réaliser des cellules solaires très haut rendement avec des étapes de lithographie que des cellules solaires bas coût réalisées dans un contexte industriel avec sérigraphie et/ou utilisation de gravure laser.

Bien que plusieurs modes de réalisation de la présente invention aient été représentés et décrits de façon détaillée, on comprendra que différents changements et modifications puissent être apportés sans sortir du cadre de l'invention. Dans les exemples décrits, le premier type de conductivité est de type n+ et le second de type p+. Il est bien sûr possible que ce soit l'inverse, l'homme du métier n'ayant aucun problème pour choisir des matériaux appropriés conduisant à ces conductivités. Plusieurs dispositifs semi-conducteurs conformes à l'invention peuvent être réalisés en même temps sur le substrat, les dispositifs unitaires peuvent ensuite être dissociés ou bien être reliés électriquement pour obtenir un module conforme à celui de la figure 2B.

## Revendications

1. Procédé de réalisation d'un dispositif semi-conducteur comportant les étapes suivantes :
- réalisation sur une première face principale (40.2) d'un substrat semi-conducteur (40) d'une région dopée (44.1) d'un premier type de conductivité et d'au moins une fenêtre (45) délimitant la dite région,
- dépôt d'une première zone (46) de métallisation sur la région dopée (44.1) du premier type de conductivité,
- dépôt d'une couche diélectrique (47) sur au moins la fenêtre (45) et la première zone (46) de métallisation,
- gravure d'au moins une première ouverture (48) dans la couche diélectrique (47) au niveau de la fenêtre (45) mettant à nu le substrat (40), destinée à accueillir une région dopée (50) d'un second type de conductivité tout en aménageant latéralement une portion non dopée (40.1) du substrat semi-conducteur entre la région dopée (50) du second type de conductivité et la région dopée (44.1) du premier type de conductivité,
- dopage du substrat (40) conduisant à la région dopée (50) du second type de conductivité,
- dépôt d'une seconde zone (50) de métallisation recouvrant la couche diélectrique (47) et venant en contact avec la région dopée (50) du second type de conductivité.

2. Procédé selon la revendication 1, **caractérisé en ce que** la région dopée (44.1) du premier type de conductivité est réalisée par dépôt d'une couche dopée (44) du premier type de conductivité sur la face principale (40.2) du substrat et gravure dans la couche dopée du premier type de conductivité de la fenêtre mettant à nu le substrat.

3. Procédé selon la revendication 1, **caractérisé en ce que** la région dopée (44.1) du premier type de conductivité est réalisée par formation d'une couche diélectrique (55) sur la face principale (40.2) du substrat, par décapage d'une partie du diélectrique (55) à l'aide d'une pâte décapante par sérigraphie formant une zone décapée au contour de la future région dopée du premier type de conductivité, par dopage de la zone décapée, par retrait du diélectrique (55) restant pour former la fenêtre (45).

4. Procédé selon la revendication 1, **caractérisé en ce que** la région dopée (44.1) du premier type de conductivité est réalisée par formation d'une couche diélectrique (55) sur la face principale (40.2) du substrat, par décapage d'une partie du diélectrique (55) à l'aide d'une pâte décapante par sérigraphie formant une zone décapée au contour de la future région dopée du premier type de conductivité, par dopage de la zone décapée, le diélectrique (55) restant formant la fenêtre (55.1).

5. Procédé selon l'une des revendications 1 à 4, **caractérisé en ce qu'**au moins une gravure est une gravure laser.

6. Procédé selon l'une des revendications 1 à 5, **caractérisé en ce qu'**au moins une des gravures est une gravure par sérigraphie.

7. Procédé selon l'une des revendications 1 à 6, **caractérisé en ce qu'**au moins une zone de métallisation se fait par sérigraphie.

8. Procédé selon l'une des revendications 1 à 7, **caractérisé en ce que** la région dopée (44.1) du premier type de conductivité et la région dopée (50) du second type de conductivité sont imbriquées l'une dans l'autre.

9. Procédé selon l'une des revendications 1 à 8, **caractérisé en ce que** la première ouverture (48) est plus petite en superficie que la fenêtre (45).

10. Procédé selon l'une des revendications 1 à 9, **caractérisé en ce que** le dépôt de la première zone (46) de métallisation sur la région dopée (44.1) du premier type de conductivité se fait avant ou après l'étape de gravure de la fenêtre (45).

11. Procédé selon la revendication 2, **caractérisé en ce que** la gravure de la couche dopée (44) du premier type de conductivité attaque le substrat (40) semi-conducteur.

12. Procédé selon l'une des revendications 1 à 11, **caractérisé en ce que** l'étape de dépôt de la seconde zone (51) de métallisation précède celle de dopage du substrat (40) conduisant à la région dopée (50) du second type de conductivité, le matériau de la seconde zone (51) de métallisation étant recuit de manière à diffuser dans le substrat au niveau de la première ouverture (48).

13. Procédé selon l'une des revendications 1 à 12, **caractérisé en ce que** le substrat (40) comporte un empilement avec une couche fragilisée (41) et une couche mince (43), la couche fragilisée étant en profondeur, la face principale (40.2) du substrat sur laquelle la couche dopée (44) du premier type de conductivité est déposée étant une face de la couche mince.

14. Procédé selon la revendication 13, **caractérisé en ce qu'**il comporte une étape de fixation de la seconde zone (51) de métallisation sur un support (52) électriquement isolant.

15. Procédé selon la revendication 14, **caractérisé en ce qu'**il comporte une étape de dissociation de la couche mince (43) du substrat au niveau de la couche fragilisée (41).

16. Procédé selon la revendication 15, **caractérisé en ce qu'**il comporte une étape de protection et de passivation de la couche mince (43) du côté où elle a été dissociée.

17. Procédé selon l'une des revendications 1 à 16, **caractérisé en ce que** l'étape de gravure de la première ouverture (48) inclut la gravure d'une seconde ouverture (49) au niveau de la première zone (46) de métallisation mettant à nu une plage de métallisation (46.1) dont est dotée la première zone (46) de métallisation.

18. Procédé selon la revendication 17, **caractérisé en ce que** l'étape de dépôt de la seconde zone (51) de métallisation épargne la seconde ouverture (49).

19. Procédé selon l'une des revendications 1 à 18, **caractérisé en ce que** le dispositif est formé d'une ou plusieurs cellules solaires (35).

20. Procédé selon la revendication 19, **caractérisé en ce que** les cellules solaires sont connectées en série et/ou en parallèle.

## Claims

1. Process for making a semiconductor device comprising the following steps:
- a doped region (44.1) with a first type of conductivity is made on a first principal face (40.2) of a semiconductor substrate (40), and at least one window (45) is made delimiting said region,
- a first metallisation area (46) is deposited on the doped region (44.1) with the first type of conductivity,
- a dielectric layer (47) is deposited on at least the window (45) and the first metallisation area (46),
- at least a first opening (48) is etched in the dielectric layer (47) at the window (45) exposing the substrate (40) that will accommodate a doped region (50) with a second type of conductivity while arranging an undoped portion (40.1) of the semiconductor substrate laterally between the doped region (50) with the second type of conductivity and the doped region (44.1) with the first type of conductivity,
- the substrate (40) is doped to create the doped region (50) with the second type of conductivity,
- a second metallisation area (50) is deposited covering the dielectric layer (47) and coming into contact with the doped region (50) with the second type of conductivity.

2. Process according to claim 1, **characterised in that** the doped region (44.1) with the first type of conductivity is made by deposition of a doped layer (44) with the first type of conductivity on the principal face (40.2) of the substrate and etching the window exposing the substrate in the doped layer with this first type of conductivity.

3. Process according to claim 1, **characterised in that** the doped region (44.1) with the first type of conductivity is made by the formation of a dielectric layer (55) on the principal face (40.2) of the substrate, by stripping a part of the dielectric (55) using a stripping paste by screen printing forming a stripped area having the contour of the future doped region with the first type of conductivity, then doping the stripped area, and then removing the remaining dielectric (55) to form the window (45).

4. Process according to claim 1, **characterised in that** the doped region (44.1) with the first type of conductivity is made by the formation of a dielectric layer (55) on the principal face (40.2) of the substrate, by stripping a part of the dielectric (55) using a stripping paste by screen printing forming a stripped area having the contour of the future doped region with the first type of conductivity and then doping the stripped area, the remaining dielectric (55) forming the window (55.1).

5. Process according to any one of claims 1 to 4, **characterised in that** at least one etching is a laser etching.

6. Process according to any one of claims 1 to 5, **characterised in that** at least one of the etchings is a screen printing etching.

7. Process according to any one of claims 1 to 6, **characterised in that** at least one metallisation area is made by screen printing.

8. Process according to any one of claims 1 to 7, **characterised in that** the doped region (44.1) with the first type of conductivity and the doped region (50) with the second type of conductivity are nested in each other.

9. Process according to any one of claims 1 to 8, **characterised in that** the first opening (48) is smaller in area than the window (45).

10. Process according to any one of claims 1 to 9, **characterised in that** the first metallisation area (46) is deposited on the doped region (44.1) with the first type of conductivity before or after the window (45) etching step.

11. Process according to claim 2, **characterised in that** etching of the doped layer (44) with the first type of conductivity attacks the semiconductor substrate (40).

12. Process according to any one of claims 1 to 11, **characterised in that** deposition step for the second metallisation area (51) precedes the doping step of the substrate (40) in which the doped region (50) with the second type of conductivity is created, the material in the second metallisation area (51) being annealed so as to diffuse into the substrate at the first opening (48).

13. Process according to any one of claims 1 to 12, **characterised in that** the substrate (40) comprises a stack with a weakened layer (41) and a thin layer (43), the weakened layer being in depth, the principal face (40.2) of the substrate on which the doped layer (44) with the first type of conductivity is deposited being a face of the thin layer.

14. Process according to claim 13, **characterised in that** it comprises a step to fix the second metallisation area (51) onto an electrically insulating support (52).

15. Process according to claim 14, **characterised in that** it comprises a step to dissociate the thin layer (43) from the substrate at the weakened layer (41).

16. Process according to claim 15, **characterised in that** it comprises a step for protection and passivation of the thin layer (43) on the side on which it was dissociated.

17. Process according to any one of claims 1 to 16, **characterised in that** the step to etch the first opening (48) includes etching of a second opening (49) at the first metallisation area (46) exposing a metallisation strip (46.1) within the first metallisation area (46).

18. Process according to claim 17, **characterised in that** the deposition step for the second metallisation area (51) does not cover the second opening (49).

19. Process according to any one of claims 1 to 18, **characterised in that** the device is formed from one or several solar cells (35).

20. Process according to claim 19, **characterised in that** the solar cells are connected in series and / or in parallel.

## Patentansprüche

1. Verfahren zur Realisierung einer Halbleitervorrichtung, die folgenden Schritte umfassend:
- Realisierung - auf einer ersten Hauptseite (40.2) eines Halbleitersubstrats (40) -, eines dotierten Bereichs (44.1) eines ersten Leitfähigkeitstyps und wenigstens eines den genannten Bereich begrenzenden Fensters (45),
- Abscheidung einer ersten Metallisierungszone (46) auf dem dotierten Bereich (44.1) des ersten Leitfähigkeitstyps,
- Abscheidung einer dielektrischen Schicht (47) auf wenigstens dem Fenster (45) der ersten Metallisierungszone (46),
- Ätzung wenigstens einer das Substrat (40) freilegenden ersten Öffnung (48) in die dielektrische Schicht (47) in Höhe des Fensters (45), dazu bestimmt, einen mit einem zweiten Leitfähigkeitstyp dotierten Bereich (50) aufzunehmen und dabei seitlich ein nichtdotiertes Teilstück (40.1) des Halbleitersubstrats zwischen dem dotierten Bereich (50) des zweiten Leitfähigkeitstyps und dem dotierten Bereich (44.1) des ersten Leitfähigkeitstyps einzurichten,
- Dotierung des Substrats (40), die zu dem dotierten Bereich (50) des zweiten Leitfähigkeitstyps führt,
- Abscheidung einer zweiten Metallisierungszone (50), welche die dielektrische Schicht (47) bedeckt und Kontakt hat dem dotierten Bereich (50) des zweiten Leitfähigkeitstyps.

2. Verfahren nach Anspruch 1, **dadurch gekennzeichnet, dass** der dotierte Bereich (44.1) des ersten Leitfähigkeitstyps realisiert wird durch Abscheiden einer dotierten Schicht (44) des ersten Leitfähigkeitstyps auf der Hauptseite (40,2) des Substrats und Ätzen des das Substrat freilegenden Fensters in die dotierte Schicht des ersten Leitfähigkeitstyps.

3. Verfahren nach Anspruch 1, **dadurch gekennzeichnet, dass** der dotierte Bereich (44.1) des ersten Leitfähigkeitstyps realisiert wird durch Bildung einer dielektrischen Schicht (55) auf der Hauptseite (40.2) des Substrats, durch Abbeizen eines Teils der dielektrischen Schicht (55) mit Hilfe einer Beizpaste durch Siebdruck zur Ausbildung einer abgebeizten Zone mit der Kontur des zukünftigen dotierten Bereichs des ersten Leitfähigkeitstyps, durch Dotierung der abgebeizten Zone, durch Schwindung des restlichen Dielektrikums (55), um das Fenster (45) zu bilden.

4. Verfahren nach Anspruch 1, **dadurch gekennzeichnet, dass** der dotierte Bereich (44.1) des ersten Leitfähigkeitstyps realisiert wird durch Bildung einer dielektrischen Schicht (55) auf der Hauptseite (40.2) des Substrats, durch Abbeizen eines Teils des Dielektrikums (55) mit Hilfe einer Beizpaste durch Siebdruck zur Ausbildung einer abgebeizten Zone mit der Kontur des zukünftigen dotierten Bereichs des ersten Leitfähigkeitstyps, durch Dotierung der abgebeizten Zone, wobei das restliche Dielektrikum (55) das Fenster (55.1) bildet.

5. Verfahren nach einem der Ansprüche 1 bis 4, **dadurch gekennzeichnet, dass** wenigstens eine der Ätzungen eine Laserätzung ist.

6. Verfahren nach einem der Ansprüche 1 bis 5, **dadurch gekennzeichnet, dass** wenigstens eine der Ätzungen eine Siebdruckätzung ist.

7. Verfahren nach einem der Ansprüche 1 bis 6, **dadurch gekennzeichnet, dass** wenigstens eine Metallisierungszone durch Siebdruck realisiert wird.

8. Verfahren nach einem der Ansprüche 1 bis 7, **dadurch gekennzeichnet, dass** der dotierte Bereich (44.1) des ersten Leitfähigkeitstyps und der dotierte Bereich (50) des zweiten Leitfähigkeitstyps ineinander verschachtelt sind.

9. Verfahren nach einem der Ansprüche 1 bis 8, **dadurch gekennzeichnet, dass** die erste Öffnung (48) eine kleinere Flächenausdehnung hat als das Fenster (45).

10. Verfahren nach einem der Ansprüche 1 bis 9, **dadurch gekennzeichnet, dass** die Abscheidung der ersten Metallisierungszone (46) auf dem dotierten Bereich (44.1) des ersten Leitfähigkeitstyps vor oder nach dem Schritt zur Ätzung des Fensters (45) erfolgt.

11. Verfahren nach Anspruch 2, **dadurch gekennzeichnet, dass** die Ätzung der dotierten Schicht (44) des ersten Leitfähigkeitstyps das Halbleitersubstrat (40) angreift.

12. Verfahren nach einem der Ansprüche 1 bis 11, **dadurch gekennzeichnet, dass** der Schritt zur Abscheidung der zweiten Metallisierungszone (51) demjenigen zur Dotierung des Substrats (40) vorausgeht, der zu dem dotierten Bereich (50) des zweiten Leitfähigkeitstyps führt, wobei das Material der zweiten Metallisierungszone (51) geglüht bzw. getempert wird, so dass es in Höhe der ersten Öffnung (48) in das Substrat diffundiert.

13. Verfahren nach einem der Ansprüche 1 bis 12, **dadurch gekennzeichnet, dass** das Substrat (40) einen Stapel mit einer dünnen Schicht (43) und einer darunterliegenden geschwächten Schicht (41) umfasst, wobei die Hauptseite (40.2) des Substrats, auf der die Schicht (44) des ersten Leitfähigkeitstyps abgeschieden ist, eine Seite der dünnen Schicht ist.

14. Verfahren nach Anspruch 13, **dadurch gekennzeichnet, dass** es einen Schritt zur Fixierung der zweiten Metallisierungszone (51) auf einem elektrisch isolierenden Träger (52) umfasst.

15. Verfahren nach Anspruch 14, **dadurch gekennzeichnet, dass** es einen Schritt zur Abtrennung der dünnen Schicht (43) des Substrats in Höhe der geschwächten Schicht (41) umfasst.

16. Verfahren nach Anspruch 15, **dadurch gekennzeichnet, dass** es einen Schritt zum Schutz und zur Passivierung der dünnen Schicht (43) auf der Seite umfasst, auf der sie abgetrennt worden ist.

17. Verfahren nach einem der Ansprüche 1 bis 16, **dadurch gekennzeichnet, dass** der Schritt zur Ätzung der ersten Öffnung (48) die Ätzung einer zweiten Öffnung (49) in Höhe der ersten Metallisierungszone (46) einschließt, die einen Metallisierungsbereich (46.1) freilegt, mit dem die erste Metallisierungszone (46) versehen ist.

18. Verfahren nach Anspruch 17, **dadurch gekennzeichnet, dass** der Schritt zur Abscheidung der zweiten Metallisierungszone (51) die zweite Öffnung (49) ausspart.

19. Verfahren nach einem der Ansprüche 1 bis 18, **dadurch gekennzeichnet, dass** die Vorrichtung durch eine oder mehrere Solarzellen (35) gebildet wird.

20. Verfahren nach Anspruch 19, **dadurch gekennzeichnet, dass** die Solarzellen serien- oder parallelgeschaltet sind.
